(19) **Europäisches Patentamt**
**European Patent Office**
**Office européen des brevets**

(11) **EP 2 735 066 B1**

(12) **EUROPÄISCHE PATENTSCHRIFT**

(45) Veröffentlichungstag und Bekanntmachung des Hinweises auf die Patenterteilung:
**28.10.2015 Patentblatt 2015/44**

(51) Int Cl.:
*H02H 7/085* *(2006.01)*　　　*H02H 5/04* *(2006.01)*
*H02H 3/08* *(2006.01)*

(21) Anmeldenummer: **11757860.9**

(22) Anmeldetag: **16.09.2011**

(86) Internationale Anmeldenummer:
**PCT/EP2011/066092**

(87) Internationale Veröffentlichungsnummer:
**WO 2013/037417 (21.03.2013 Gazette 2013/12)**

(54) **VORRICHTUNG UND VERFAHREN ZUM SCHUTZ EINES VERBRAUCHERS**

DEVICE AND METHOD FOR PROTECTING A CONSUMER

DISPOSITIF ET PROCÉDÉ DE PROTECTION D'UN CONSOMMATEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**28.05.2014 Patentblatt 2014/22**

(73) Patentinhaber: **Siemens Aktiengesellschaft 80333 München (DE)**

(72) Erfinder:
* **BEHRINGER, Klaus**
  **91338 Igensdorf (DE)**
* **MAIER, Martin**
  **92681 Erbendorf (DE)**
* **PFITZNER, Klaus**
  **92224 Amberg (DE)**
* **RÖSCH, Bernhard**
  **92237 Sulzbach-Rosenberg (DE)**

(56) Entgegenhaltungen:
**DE-A1- 10 213 617　　US-A- 3 680 325**

**Beschreibung**

Die Erfindung betrifft eine Vorrichtung und ein Verfahren zum Schutz eines Verbrauchers vor einer Überlast, insbesondere einer thermischen Überlast.

Als Verbraucher wird hierbei insbesondere ein Elektromotor (z.B. Asynchronmotor) gesehen. Eine thermische Überlast am Verbraucher wird beispielsweise durch eine mechanische Überlast an einem Elektromotor oder durch einen Ausfall eines Strompfades (Phase) des Elektromotors hervorgerufen. Hierbei kommt es zu einer unerwünschten Temperaturentwicklung am Verbraucher, was letztendlich zu einer Beschädigung des Verbrauchers führen kann.

Zur Ermittlung einer anstehenden thermischen Überlast eines elektrischen Verbrauchers werden meist Vorrichtungen in den Strompfad, über welchen der Verbraucher mit elektrischer Energie versorgt wird, integriert, so dass mittels dieser Vorrichtungen eine anstehende thermische Überlast des Verbrauchers detektiert werden kann. Hierbei kann eine einphasige aber auch eine mehrphasige Überwachung erfolgen, d.h. es kann ein einzelner Strompfad (eine Phase) aber auch mehrere Strompfade (mehrere Phasen) des Verbrauchers überwacht werden.

Die entsprechenden Vorrichtungen weisen je zu überwachenden Strompfad eine Strombahn auf, über welche die über den Strompfad erfolgende Energieversorgung geführt wird. Die elektrische Energie des Verbrauchers wird somit mittels der Strombahn durch die Vorrichtung geleitet. Mittels einer Überwachungseinrichtung der Vorrichtung wird der Stromfluss der Strombahn überwacht, so dass eine anstehende Überlast des Verbrauchers detektiert werden kann. Derartige Vorrichtungen sind beispielsweise Überlastrelais oder Leistungsschalter. Ein Leistungsschalter weist für einen nachgeschalteten Verbraucher neben einem Schütz vor einer thermischen Überlast durch einen A-Auslöser ferner einen Kurzschlussschutz durch einen N-Auslöser auf.

In der vorliegenden Anmeldung soll insbesondere ein Überlastschutz für einen Verbraucher (z.B. Motoren, Leitungen, Transformatoren und Generatoren) bereitgestellt werden.

An eine Vorrichtung zur Ermittlung einer thermischen Überlast eines Verbrauchers werden unterschiedliche Anforderungen gestellt:

- Die Vorrichtung soll möglichst sowohl AC- als auch DC-Ströme überwachen können, so dass sowohl AC- als auch DC-Verbraucher auf Überlast überwacht werden können.

- Die Vorrichtung soll einen möglichst großen Einstellbereich aufweisen. Der Einstellbereich ist der Bereich, in welchen eine Überwachung des Betriebsstromes des elektrischen Verbrauchers erfolgen kann. Er wird durch die Betriebsstromobergrenze $I_O$ und Betriebsstromuntergrenze $I_U$ begrenzt ($I_O$ zu $I_U$). Mittels eines Einstellmittels (z.B. Einstellschraube) an der Vorrichtung kann der thermische Überlastauslöser auf den jeweiligen Anlagestrom eingestellt werden, so dass eine gezielte Überwachung des nachgeschalteten zu überwachenden Verbrauchers erfolgen kann.

- Die Vorrichtung soll eine möglichst geringe Verlustleistung erzeugen.

- Die Vorrichtung soll eine möglichst einfache galvanische Trennung zwischen der zu überwachenden Strombahn und der Überwachungseinrichtung, welche die Überlast detektiert, aufweisen.

- Die Vorrichtung soll ein thermisches Gedächtnis besitzen. D.h. wird eine anstehende thermische Überlast eines Verbrauchers ermittelt, so sollte die Stromzufuhr zum Verbraucher solange unterbrochen werden, bis ein Abkühlen des Verbrauchers sichergestellt ist. Es sollte somit kein sofortiges Zuschalten eines Verbrauchers nach einer ermittelten thermischen Überlast ermöglicht werden.

Bei einer anstehenden thermischen Überlast eines Verbrauchers kommt es in den einzelnen Strompfaden (Phasen) des Verbrauchers zu einem erhöhten Stromanstieg. Eine dem Verbraucher vorgeschaltete Einrichtung zur Überwachung einer thermischen Überlast des Verbrauchers kann folglich durch eine Überwachung seiner Strombahn diesen erhöhten Stromanstieg detektieren und auswerten. Hierfür können unterschiedliche Messprinzipien angewandt werden. Die Ermittlung einer anstehenden Überlast kann somit mittels unterschiedlicher Überwachungseinrichtungen der Vorrichtung erfolgen. Überwachungseinrichtungen zur Detektion einer Überlast eines Verbrauchers umfassen insbesondere je zu überwachende Phase des Verbrauchers an der entsprechenden Strombahn einen Bimetallauslöser, einen Stromwandler oder einen Shunt.

Bei einer Überwachung mittels eines Bimetallauslösers wird die zu überwachende Strombahn mit einem Bimetallauslöser derart gekoppelt, dass es durch den Stromanstieg zu einer Erwärmung des Bimetallauslösers und letztendlich zu einer räumlichen Auslenkung eines Teils des Bimetallauslösers kommt. Diese Auslenkung wird detektiert und weiter ausgewertet. Mittels eines Bimetallauslösers können sowohl Gleichströme als auch Wechselströme erfasst werden. Der typische Einstellbereich des Bimetallauslösers liegt bei 1 zu 1,6. Nachteilig am Bimetallauslöser ist, dass er eine hohe Verlustleistung generiert. Das thermische Gedächtnis und die galvanische Trennung zwischen den einzelnen Strompfaden (Phasen) sind bei dem Bimetallauslöser mit geringem Aufwand zu realisieren.

Bei einer Überwachung mittels eines Stromwandlers ermittelt der jeweilige Stromwandler den Stromfluss seiner Strombahn, so dass eine Auswerteeinheit eine weiterführende Analyse des Stromflusses durchführen kann, und letztendlich eine anstehende Überlast detektieren kann. Nachteilig dieser Messmethode ist, dass keine DC-Ströme erfasst werden können. Der Einstellbereich liegt bei 1 zu 10 und die Verlustleistung ist niedrig. Ein thermisches Gedächtnis kann jedoch durch die Stromwandler selbst nicht nachgebildet werden.

Bei einer Überwachung mittels eines Shunts ist der Shunt in der Strombahn integriert, so dass über diesen ein den Stromfluss charakterisierender Spannungsabgriff erfolgen kann. Durch eine nachgeschaltete Analyse der am Shunt anliegenden Spannung kann eine anstehende thermische Überlast ermittelt werden. Mittels eines Shunt-Messverfahren ist eine Erfassung von AC/DC-Strömen möglich. Der Einstellbereich liegt üblicherweise bei 1 zu 4. Nachteilig an dem Messverfahren mittels eines Shunts ist, dass durch den Spannungsabgriff am Shunt kein thermisches Gedächtnis nachgebildet wird und die galvanische Trennung der einzelnen Phasen nur mit großem Aufwand möglich ist.

Eine Aufgabe der vorliegenden Erfindung ist es eine Vorrichtung sowie ein Verfahren bereitzustellen, mit welcher eine Ermittlung einer anstehenden Überlast eines Verbrauchers erfolgen kann. Insbesondere sollen mittels der Vorrichtung sowohl Gleichströme als auch Wechselströme überwacht werden können. Ferner soll vorzugsweise eine einfache galvanische Trennung der Überwachungseinrichtung von der zu überwachenden Strombahn ermöglicht werden.

Diese Aufgabe wird gelöst durch eine Vorrichtung gemäß Anspruch 1, d.h. durch eine Vorrichtung, zum Schutz eines Verbrauchers, mit einer ersten Strombahn, welche zwei Leitungen umfasst, und einer Überwachungseinrichtung, zur Ermittlung einer anstehenden Überlast des Verbrauchers, wobei die Überwachungseinrichtung eine erste Temperaturmesseinheit, eine Auswerteeinheit und ein erstes Messelement, welches eine elektrisch leitende Verbindung zwischen den zwei Leitungen der ersten Strombahn herstellt, umfasst, wobei die erste Temperaturmesseinheit von dem ersten Messelement galvanisch getrennt ist und einen ersten und einen zweiten Temperaturfühler umfasst, wobei der erste und zweite Temperaturfühler der ersten Temperaturmesseinheit gleichzeitig jeweils eine Temperatur des ersten Messelements erfassen kann und die Auswerteeinheit anhand der erfassten Temperaturen der ersten Temperaturmesseinheit eine anstehende Überlast am Verbraucher ermitteln kann, und einem Verfahren gemäß Anspruch 12, d.h. durch ein Verfahren zum Schutz eines Verbrauchers, wobei eine Vorrichtung eine erste Strombahn, welche zwei Leitungen umfasst, und eine Überwachungseinrichtung, zur Ermittlung einer anstehenden Überlast des Verbrauchers, umfasst, wobei die Überwachungseinrichtung eine erste Temperaturmesseinheit, eine Auswerteeinheit und ein erstes Messelement, welches eine elektrisch leitende Verbindung zwischen den zwei Leitungen der ersten Strombahn herstellt, umfasst, wobei die erste Temperaturmesseinheit von dem ersten Messelement galvanisch getrennt ist und einen ersten und einen zweiten Temperaturfühler umfasst, wobei der erste und zweite Temperaturfühler jeweils eine Temperatur des ersten Messelements erfasst und die Auswerteeinheit anhand der erfassten Temperaturen der ersten Temperaturmesseinheit eine anstehende Überlast am Verbraucher ermittelt.

Vorteilhafte Weiterbildungen der Erfindung sind in den abhängigen Ansprüchen 2 bis 11 und 13 angegeben.

Die Strombahn ist insbesondere ein Teil einer Zuleitung der Energieversorgung des Verbrauchers. Die Zuleitung wird ebenso Hauptstrombahn oder Phase genannt. Im aktiven Betrieb des Verbrauchers (z.B. Elektromotor) fließt durch die Strombahn und somit durch das erste Messelement ein zeitabhängiger Motorstrom, welcher im ersten Messelement in Abhängigkeit der Stromhöhe und der Stromflusszeit zu einer definierten Erwärmung des ersten Messelements (strombedingte Erwärmung) führt. Das erste Messelement weist hierbei in Abhängigkeit der vorliegenden Stromhöhe und Stromflusszeit ein charakteristisches Erwärmungsverhalten auf.

Bei einer anstehenden Überlast des Verbrauchers ist der thermische Zustand des ersten Messelements gegenüber dem Zustand im Standardbetrieb des Verbrauchers unterschiedlich. Insbesondere liegt bei einer anstehenden Überlast am ersten Messelement eine erhöhte Temperatur und folglich eine charakteristisches Erwärmungsverhalten des ersten Messelements vor.

Bei einer strombedingten Erwärmung des ersten Messelements ist die Temperatur am ersten Messelement nicht über den gesamten Körper des ersten Messelements einheitlich. Es gibt am ersten Messelement Bereiche, welche zum selben Zeitpunkt eine höhere oder niedrige Temperatur aufweisen, als ein anderer Bereich des ersten Messelements. Weist beispielsweise das erste Messelement eine einheitliche geschlossene rechteckige Form auf, so ist die Temperatur üblicherweise im mittleren Bereich der Längsachse des ersten Messelements höher als im Anfangs- und Endbereich der Längsachse des ersten Messelements. In Abhängigkeit des Stromflusses durch das erste Messelement liegt folglich ein charakteristisches Erwärmungsverhalten des ersten Messelements vor. Mittels der ersten Messeinheit wird dieses strombedingte charakteristische Erwärmungsverhalten des ersten Messelements erfasst, so dass die Auswerteeinheit einen Rückschluss auf den Zustand Stromfluss am ersten Messelement und letztendlich auf den aktuellen Zustand des Verbrauchers gewinnen kann. Es kann somit ermittelt werden ob ein ordnungsgemäßer Betrieb am Verbraucher vorliegt oder eine Überlast ansteht.

Ein Anstieg der Umgebungstemperatur (externer Temperatureinfluss) kann beispielsweise ebenso zu einem Temperaturanstieg am ersten Messelement führen, so dass eine Ermittlung einer Anstehenden Überlast anhand einer Ermittlung lediglich einer Temperatur am ersten Messelement zu einer verfälschten Analyse führen würde.

Um bei der Ermittlung einer anstehenden Überlast derartige externe Temperatureinflüsse zu minimieren, werden durch die erste Temperaturmesseinheit zeitgleich insbesondere zwei Temperaturen des ersten Messelements erfasst. Die Messung der Temperaturen des ersten Messelements erfolgt hierbei an zwei Messpunkten des ersten Messelements, welche bei einer strombedingten Erwärmung des ersten Messelements zeitgleich unterschiedliche Temperaturen aufweisen können.

Mittels der zeitgleich erfassten Temperaturen des ersten Messelements kann die Auswerteeinheit folglich einen Temperaturdifferenzwert ($\Delta T_n$) des ersten Messelements berechnen. Mittels des berechneten Temperaturdifferenzwerts ($\Delta T_n$) kann nun durch die Auswerteeinheit ein Rückschluss auf die strombedingte Erwärmung des ersten Messelements gewonnen werden. Hierfür wird beispielsweise die Temperatur des zweiten Temperaturfühlers ($T_{n2}$) von der zeitgleich erfassten Temperatur des ersten Temperaturfühlers ($T_{n1}$) subtrahiert; ($\Delta T_n = T_{n2} - T_{n1}$). Bei einer gleichzeitigen Ermittlung mehrerer Temperaturen des ersten Messelements mittels mehrer Temperaturfühler können äquivalente Berechnungen erfolgen, um einen Temperaturdifferenzwert ($\Delta T_n$) des ersten Messelements zu ermitteln. Die Berechung des Temperaturdifferenzwerts ($\Delta T_n$) erfolgt insbesondere mittels der Auswerteeinheit.

Der Vorteil der Auswertung mit dem Temperaturdifferenzwert ($\Delta T_n$) ist insbesondere, dass äußere Temperatureinflüsse weitestgehend kompensiert werden können, so dass hauptsächliche die strombedingte Erwärmung am ersten Messelement betrachtet werden kann. Es kann folglich eine exakte Analyse einer strombedingten Erwärmung des ersten Messelements erfolgen, so dass eine verbesserte Ermittlung einer anstehenden Überlast des Verbrauchers erfolgen kann.

Mittels des ersten und zweiten Temperaturfühlers wird folglich jeweils eine Temperatur des ersten Messelements zeitgleich erfasst und der Auswerteeinheit bereitgestellt. Die Auswerteeinheit kann somit je Zyklus (Intervall, in welchem durch die erste Temperaturmesseinheit Temperaturen zeitgleich ermittelt werden) einen Temperaturdifferenzwert ($\Delta T_n$) ermitteln und auswerten. Sie kann somit vorzugsweise je Zyklus kontrollieren, ob ein strombedingtes Erwärmungsverhalten des ersten Messelements, welches eine anstehende Überlast des Verbrauchers charakterisiert, stattgefunden hat oder nicht.

Das erste Messelement ist vorzugsweise ein Widerstand (z.B. Shunt) mit einer konstanten Verlustleistung.

Die Auswertung des Temperaturdifferenzwerts ($\Delta T_n$) durch die Auswerteeinheit zur Ermittlung einer anstehenden Überlast des Verbrauchers kann unterschiedlich erfolgen. Hierfür ist vorzugsweise ein Referenzwert in der Auswerteeinheit hinterlegt, welcher mit einem Temperaturdifferenzwert ($\Delta T_n$) oder mehreren Temperaturdifferenzwerten ($\Delta T_n$) oder einem hieraus gebildeten Wert verglichen werden kann, so dass eine anstehende Überlast am Verbraucher ermittelt werden kann. Durch den Referenzwert wird somit vorzugsweise das strombedingte Erwärmungsverhalten des ersten Messelements charakterisiert.

Ein mit der Erfindung erzielte Vorteil besteht insbesondere darin, dass mittels einer derartigen Vorrichtung bzw. mittels eines derartigen Verfahrens sowohl AC- als auch DC-Ströme erfasst werden können. Es kann somit eine anstehende Überlast bei AC- und DC-Verbrauchern ermittelt werden. Ferner kann ein gegenüber einem Bimetall-Messverfahren verbesserter Einstellbereich erzielt werden. Ebenso kann ein thermisches Gedächtnis realisiert werden, da bei einer anstehenden Überlast das erste Messelement stark erhitzt wird, so dass anhand der Temperatur und somit Abkühlung des ersten Messelements ein Abkühlverhalten des Verbrauchers nachvollzogen werden kann. Eine derartige Auswertung kann beispielsweise ferner durch die Auswerteeinheit realisiert werden.

In einer vorteilhaften Ausführungsform der Erfindung umfasst die erste Temperaturmesseinheit ferner einen dritten Temperaturfühler, welcher gleichzeitig mit dem ersten und zweiten Temperaturfühler der ersten Temperaturmesseinheit eine Temperatur des ersten Messelements erfassen kann. Durch den dritten Temperaturfühler ($T_{n3}$) erfolgt insbesondere eine Temperaturerfassung an einem Messpunkt der ersten Messeinheit, welche durch den ersten und zweiten Temperaturfühler der ersten Temperaturmesseinheit nicht erfasst wird. Der Messpunkt des dritten Temperaturfühlers am ersten Messelement weist in mindestens einem stromdurchflossenen Zustand des ersten Messelements vorzugsweise eine andere Temperatur auf als der Messpunkt des zweiten Temperaturfühlers am ersten Messelement.

Mit dem ersten, zweiten und dritten Temperaturfühler wird vorzugsweise die gleiche Seitenfläche des ersten Messelements überwacht. Auf diese Weise kann eine äußerst präzise Ermittlung des Erwärmungsverhaltens des ersten Messelements erfolgen.

In einer weiteren vorteilhaften Ausführungsform der Erfindung ist der erste, zweite und dritte Temperaturfühler derart zum ersten Messelement angeordnet, dass der erste Temperaturfühler eine Temperatur an einem ersten Messpunkt des ersten Messelements erfassen kann, der zweite Temperaturfühler eine Temperatur an einem zweiten Messpunkt des ersten Messelements erfassen kann und der dritte Temperaturfühler eine Temperatur an einem dritten Messpunkt des ersten Messelements erfassen kann, wobei in Bezug zu einer ersten Seitenfläche des ersten Messelements der zweite Messpunkt zwischen dem ersten und dritten Messpunkt auf der ersten Seitenfläche liegt.

Vorzugsweise liegt in mindestens einem stromdurchflossenen Zustand des ersten Messelements am zweiten Messpunkt im Vergleich zum ersten und dritten Messpunkt eine höhere Temperatur vor. Der erste Messpunkt Befindet sich hierbei insbesondere im Anfangsbereich einer Achse der Seitenfläche des ersten Messelements, der dritte Messpunkt im Endbereich der Achse und der zweite Messpunkt im mittleren Bereich der Achse der Seitenfläche des ersten Messelements. Die Achse der Seitenfläche des ersten Messelements ist vorzugsweise die Längsachse der Seitenfläche.

Zur Ermittlung des Temperaturdifferenzwerts ($\Delta T_n$) kann nun beispielsweise folgende Formel angewandt werden:

$$\Delta T_n = \frac{(T_{n2} - T_{n1}) + (T_{n2} - T_{n3})}{2} = T_{n2} - \left(\frac{T_{n1} + T_{n3}}{2}\right)$$

$\Delta T_n$: Temperaturdifferenzwert

$T_{n1}$ Ermittelte Temperatur des ersten Temperaturfühlers am ersten Messpunkt

$T_{n2}$: Ermittelte Temperatur des zweiten Temperaturfühlers am zweiten Messpunkt

$T_{n3}$: Ermittelte Temperatur des dritten Temperaturfühlers am dritten Messpunkt

n: Betrachtetes Messelement und somit betrachtete Strombahn.

Der Temperaturdifferenzwert kann durch die Auswerteeinheit je Zyklus einer zeitgleichen Ermittlung der einzelnen Temperaturen der Temperaturfühler ermittelt werden. Durch eine entsprechende Auswertung des Temperaturdifferenzwerts in der Auswerteeinheit kann letztendlich erkannt werden ob ein ordnungsgemäßer Betrieb des Verbrauchers vorliegt oder ob eine Überlast am Verbraucher ansteht oder bereits vorliegt.

In einer weiteren vorteilhaften Ausführungsform der Erfindung ist der jeweilige Temperaturfühler maximal 2 mm von dem ersten Messelement beabstandet. Hierdurch kann eine genaue Erfassung der Temperatur des entsprechenden Messpunkts am ersten Messelement durch den entsprechenden Temperaturfühler erfolgen.

In einer weiteren vorteilhaften Ausführungsform der Erfindung ist zwischen den Temperaturfühlern der ersten Temperaturmesseinheit und dem Messelement eine elektrisch isolierende Isolationsschicht angeordnet. Hierdurch kann eine sichere galvanische Trennung der ersten Temperaturüberwachungseinrichtung zum ersten Messeelement sichergestellt werden. Durch die elektrisch isolierende Isolationsschicht wird vorzugsweise eine gute thermische Kopplung der Temperaturfühler mit dem entsprechenden Messelement bereitgestellt. Die elektrisch isolierende Isolationsschicht wird vorzugsweise als Träger für die Temperaturfühler verwendet, so dass die Temperaturfühler auf dem Träger befestigt sind. Die elektrisch isolierende Isolationsschicht ist beispielsweise FR4 oder eine Keramik.

In einer weiteren vorteilhaften Ausführungsform der Erfindung kann die Auswerteeinheit anhand der durch die Temperaturfühler zeitgleich ermittelten Temperaturen des ersten Messelements einen Temperaturdifferenzwert ($\Delta T_n$) des ersten Messelements ermitteln. Steht eine Überlast am Verbraucher an, so liegt im Vergleich zum Normalbetrieb/Nennbetrieb ein erhöhter Stromfluss und somit eine erhöhte strombedingte Erwärmung am ersten Messelement vor. Das erste Messelement weist folglich ein charakteristisches thermisches Verhalten auf, welches mittels des Temperaturdifferenzwertes erfasst werden kann. Durch den vorzugsweise in der Auswerteeinheit hinterlegten Referenzwert wird insbesondere das Erwärmungsverhalten des ersten Messelements in Abhängigkeit des Stromflusses und der Stromflusszeit durch das erste Messelement charakterisiert. Durch einen Vergleich des Temperaturdifferenzwerts ($\Delta T_n$) des ersten Messelements mit dem Referenzwert kann somit zwischen einem durch den Normalbetrieb strombedingten Erwärmungsverhalten und einem durch eine anstehende Überlast strombedingten Erwärmungsverhalten des ersten Messelements unterschieden werden. Der Vergleich mit dem Referenzwert kann hierbei mit einem einzigen Temperaturdifferenzwert ($\Delta T_n$) aber auch mit mehreren Temperaturdifferenzwerten ($\Delta T_n$) erfolgen.

In einer weiteren vorteilhaften Ausführungsform der Erfindung kann die Auswerteeinheit bei einer ermittelten anstehenden Überlast am Verbraucher ein Warnsignal, insbesondere ein elektrisches Warnsignal, ausgeben. Durch das Warnsignal wird vorzugsweise eine Schaltstellung eines Schaltelements der Vorrichtung gesteuert. Durch das Schaltelement wird entweder ein Hilfsstromkreis oder ein Hauptstromkreis (Zuleitung der Energieversorgung des elektrischen Verbrauchers) direkt gesteuert.

Steuert das Schaltelement den Hilfsstromkreis, so wird das Schaltelement geöffnet oder geschlossen, so dass ein den Hauptstromkreis schaltendes Schaltgerät (z.B. Schütz) angesteuert wird. Dieses den Hauptstromkreis schaltende Schaltgerät öffnet daraufhin den Hauptstromkreis, so dass der Stromfluss zum Verbraucher unterbrochen wird und somit die Überlast am Verbraucher vermieden wird.

Steuert das Schaltelement den Hauptstromkreis, so wird das Schaltelement geöffnet, so dass der Stromfluss zum Verbraucher unterbrochen wird und somit die Überlast am Verbraucher vermieden wird.

Liegt ein mehrphasiger Verbraucher vor, so werden vorzugsweise durch eine Ermittlung einer anstehenden Überlast an lediglich einer Strombahn der Vorrichtung (und somit an lediglich einer Phase des Verbrauchers) alle Phasen des Verbrauchers geöffnet, so dass der Stromfluss zum Verbraucher vollständig unterbunden wird.

In einer weiteren vorteilhaften Ausführungsform der Erfindung umfasst die Vorrichtung ferner eine zweite Strombahn, welche zwei Leitungen umfasst, wobei die Überwachungseinrichtung ferner eine zweite Temperaturmesseinheit und ein zweites Messelement, welches eine elektrisch leitende Verbindung zwischen den zwei Leitungen der zweiten Strombahn herstellt, umfasst, wobei die zweite Temperaturmesseinheit von dem zweiten Messelement galvanisch getrennt ist und einen ersten und einen zweiten Temperaturfühler umfasst, wobei der erste und zweite Temperaturfühler der zweiten Temperaturmesseinheit gleichzeitig jeweils eine Temperatur des zweiten Messelements erfassen kann und die Auswerteeinheit anhand der erfassten Temperaturen der zweiten Temperaturmesseinheit eine anstehende Überlast am Verbraucher ermitteln kann. Der erste und zweite Temperaturfühler ist insbesondere derart zum zweiten Messelement angeordnet, dass durch eine zeitgleiche Erfassung der Temperatur durch die Auswerteeinheit ein strombedingtes charakteristisches Erwärmungsverhalten des zweiten Messelements ermittelbar ist.

In der Auswerteeinheit ist vorzugsweise ein Referenzwert hinterlegt, welcher das Erwärmungsverhalten des zweiten Messelements charakterisiert. Die Auswerteeinheit kann somit durch einen Vergleich des ermittelten strombedingten Erwärmungsverhaltens des zweiten Messelements mit dem in der Auswerteeinheit hinterlegten Referenzwert eine anstehende Überlast am Verbraucher ermitteln. Anhand des strombedingten charakteristischen Erwärmungsverhaltens des zweiten Messelements kann somit die Auswerteeinheit zwischen dem Normalbetrieb und einer anstehenden Überlast unterscheiden.

In einer weiteren vorteilhaften Ausführungsform der Erfindung umfasst die zweite Temperaturmesseinheit ferner einen dritten Temperaturfühler, welcher gleichzeitig mit dem ersten und zweiten Temperaturfühler der zweiten Temperaturmesseinheit eine Temperatur des zweiten Messelements erfassen kann. Hierbei erfolgt insbesondere eine Temperaturerfassung an einem Messpunkt der zweiten Messeinheit, welche durch den ersten und zweiten Temperaturfühler der zweiten Temperaturmesseinheit nicht erfasst wird.

Die Anordnung der Temperaturfühler der zweiten Temperaturmesseinheit gegenüber dem zweiten Messelement kann entsprechend der Anordnung der ersten Temperaturmesseinheit gegenüber dem ersten Messelement ausgebildet sein. Ebenso kann die Auswertung der erfassten Temperaturen der zweiten Temperaturmesseinheit durch die Auswerteeinheit äquivalent zur Auswertung der Temperaturen der ersten Temperaturmesseinheit durch die Auswerteeinheit erfolgen. Ferner kann eine elektrisch isolierende Isolationsschicht (wie zwischen dem ersten Messelement und der ersten Temperaturmesseinheit) zwischen den Temperaturfühlern der zweiten Temperaturmesseinheit und dem zweiten Messelement angeordnet sein.

In einer weiteren vorteilhaften Ausführungsform der Erfindung umfasst die Vorrichtung eine dritte Strombahn, welche zwei Leitungen umfasst, wobei die Überwachungseinrichtung ferner eine dritte Temperaturmesseinheit und ein drittes Messelement, welches eine elektrisch leitende Verbindung zwischen den beiden Leitungen der dritten Strombahn herstellt, umfasst, wobei die dritte Temperaturmesseinheit von dem dritten Messelement galvanisch getrennt ist und einen ersten und einen zweiten Temperaturfühler umfasst, wobei der erste und zweite Temperaturfühler der dritten Temperaturmesseinheit gleichzeitig jeweils eine Temperatur des dritten Messelements erfassen kann und die Auswerteeinheit anhand der erfassten Temperaturen der dritten Temperaturmesseinheit eine anstehende Überlast am Verbraucher ermitteln kann. Der erste und zweite Temperaturfühler ist insbesondere derart zum dritten Messelement angeordnet, dass durch eine zeitgleiche Erfassung der Temperatur durch die Auswerteeinheit ein strombedingtes Erwärmungsverhalten des dritten Messelements ermittelbar ist.

Die Auswerteeinheit kann vorzugsweise durch einen Vergleich des ermittelten Erwärmungsverhaltens des dritten Messelements mit einem in der Auswerteeinheit hinterlegten Referenzwert eine anstehende Überlast am Verbraucher ermitteln. Durch den Referenzwert ist der Auswerteeinheit insbesondere das Erwärmungsverhalten des dritten Messelements bekannt, so dass eine anstehende Überlast des Verbrauchers ermittelt werden kann.

In einer weiteren vorteilhaften Ausführungsform der Erfindung umfasst die dritte Temperaturmesseinheit ferner einen dritten Temperaturfühler, welcher gleichzeitig mit dem ersten und zweiten Temperaturfühler der dritten Temperaturmesseinheit eine Temperatur des ersten Messelements erfassen kann. Hierbei erfolgt insbesondere eine Temperaturerfassung an einem Messpunkt der dritten Messeinheit, welche durch den ersten und zweiten Temperaturfühler der dritten Temperaturmesseinheit nicht erfasst wird.

Die Anordnung der Temperaturfühler der dritten Temperaturmesseinheit gegenüber dem dritten Messelement kann entsprechend der Anordnung der ersten Temperaturmesseinheit gegenüber dem ersten Messelement ausgebildet sein. Ebenso kann die Auswertung der erfassten Temperaturen der dritten Temperaturmesseinheit durch die Auswerteeinheit äquivalent zur Auswertung der Temperaturen der ersten Temperaturmesseinheit durch die Auswerteeinheit erfolgen. Ferner kann eine elektrisch isolierende Isolationsschicht (wie zwischen dem ersten Messelement und der ersten Temperaturmesseinheit) zwischen den Temperaturfühlern der dritten Temperaturmesseinheit und dem dritten Messelement angeordnet sein.

Die elektrisch isolierende Isolationsschicht ist vorzugsweise ein Trägermaterial für die entsprechenden Temperaturfühler. Hierbei sind vorzugsweise die Temperaturfühler der ersten, zweiten und dritten Temperaturmesseinheit auf derselben Isolationsschicht platziert.

Es ist ebenso denkbar, dass die erste und/oder zweite und/oder dritte Temperaturmesseinheit weitere Temperaturfühler umfasst, so dass eine genauere Ermittlung des strombedingten Erwärmungsverhaltens des zugehörigen Messelements erfolgen kann.

In einer weiteren vorteilhaften Ausführungsform der Erfindung ist der jeweilige Temperaturfühler derart ausgebildet, dass er in Abhängigkeit der vorliegenden Temperatur einen charakteristischen Zustand einnimmt. Der Temperaturfühler ist insbesondere ein Thermocouble, Thermodraht oder temperaturabhängiger Halbleiter (z.B. Diode). Wird beispielsweise eine Diode als Temperaturfühler verwendet, so kann anhand einer Messung der Spannung an der Diode ein Rückschluss auf die vorliegende Temperatur gewonnen werden. Eine Temperaturänderung des ersten Messelements würde folglich zu einer Temperaturänderung an der Diode führen, welche zu einer Spannungsänderung führt.

In einer weiteren vorteilhaften Ausführungsform der Erfindung ist das erste Messelement und sofern vorhanden zweite und/oder dritte Messelement jeweils ein elektrischer Widerstand, insbesondere ein Shunt. Vorzugsweise weist das Messelement eine konstante Verlustleistung und eine strombedingtes charakteristisches Erwärmungsverhalten auf.

Der Auswerteeinheit liegt vorzugsweise ein Teil des Erwärmungsverhaltens des jeweiligen Messelements als Referenzwert vor, so dass sie durch einen Vergleich des ermittelten strombedingten Erwärmungsverhaltens des Messelements mit dem Referenzwert eine anstehende Überlast erkennen kann. Sind die Messelemente und die zugehörigen Temperaturfühler der Temperaturmesseinheit gleich ausgebildet, so ist der Referenzwert für die Messelemente gleich.

In einer weiteren vorteilhaften Ausführungsform der Erfindung ist die Vorrichtung ein Schaltgerät, insbesondere ein Überlastrelais oder ein Leistungsschalter. Die Vorrichtung ist vorzugsweise dezentral vom Verbraucher angeordnet, d.h. sie ist kein Bestandteil des Verbrauchers (z.B. Elektromotor).

Die Temperaturfühler der ersten, zweiten und/oder dritten Temperaturmesseinheit können vorzugsweise Temperaturunterschiede von ca. 4 Kelvin erfassen.

Das erste, zweite und/oder dritte Messelement weist vorzugsweise im Nennbetrieb eine Temperatur von ca. 60-100°C auf. Bei einer maximalen Überlast am Verbrauche kann hingegen eine Temperatur von 600-700°C am entsprechenden Messelement vorliegen.

Im Folgenden werden die Erfindung und Ausgestaltungen der Erfindung anhand der in den Figuren dargestellten Ausführungsbeispiele näher beschrieben und erläutert. Es zeigen:

FIG 1     eine schematische Darstellung einer ersten Strombahn, welche eine Überwachungseinrichtung aufweist,

FIG 2     eine schematische Darstellung einer Vorrichtung zum Schutz eines elektrischen Verbrauchers, und

FIG 3     eine schematische Darstellung einer Vorrichtung zum Schutz eines elektrischen Verbrauchers, wobei eine Überwachungseinrichtung auf einer Leiterplatte aufgebracht ist.

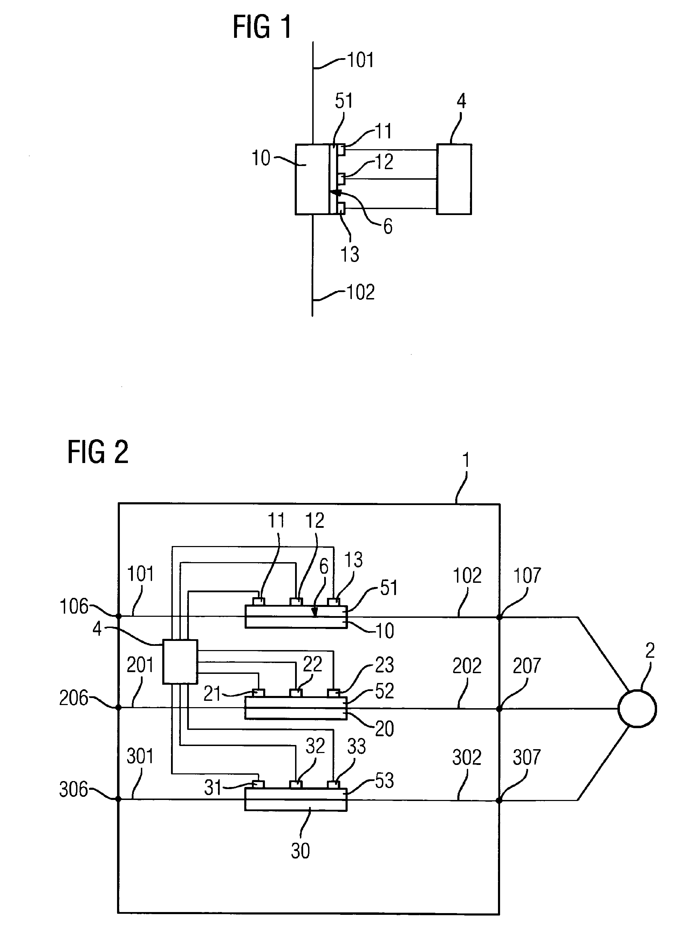

FIG 1 zeigt eine schematische Darstellung einer ersten Strombahn, welche eine Überwachungseinrichtung aufweist. Die abgebildete Strombahn ist Bestandteil einer Vorrichtung zum Schutz eines nachgeschalteten Verbrauchers. Mittels der Überwachungseinrichtung kann eine anstehende Überlast des Verbrauchers ermittelt werden. Hierfür wird die Vorrichtung in den Strompfad des Verbrauchers integriert. Ist beispielsweise der Verbraucher ein dreiphasiger Drehstrommotor so weist mindestens eine Zuleitung (Phase) des Drehstrommotors die abgebildete Strombahn und Überwachungseinrichtung auf.

Die erste Strombahn umfasst eine erste Leitung 101 und eine zweite Leitung 102. Die Überwachungseinrichtung umfasst eine erste Temperaturmesseinheit, eine Auswerteeinheit 4 und ein erstes Messelement 10. Die erste Temperaturmesseinheit umfasst einen ersten Temperaturfühler 11, einen zweiten Temperaturfühler 12 und einen dritten Temperaturfühler 13.

Das erste Messelement 10 ist zwischen der ersten Leitung 101 und der zweiten Leitung 102 der ersten Strombahn angeordnet, so dass ein Strom von der ersten Leitung 101 über das erste Messelement 10 zur zweiten Leitung 102 fließen kann. Da über die erste und zweite Leitung 101,102 die Energieversorgung des nachgeschalteten Verbrauchers erfolgt, fließt während des Betriebs des nachgeschalteten Verbrauchers der Strom über das erste Messelement 10. In Abhängigkeit des vorliegenden Betriebszustandes des nachgeschalteten Verbrauchers liegt eine Stromhöhe am ersten Messelement 10 vor. In Abhängigkeit dieser Stromhöhe und der Stromflusszeit am ersten Messelement 10 liegt ein charakteristisches Erwärmungsverhalten des ersten Messelementes 10 vor. Mittels der Temperaturfühler 11,12,13 kann das charakteristische Erwärmungsverhalten des ersten Messelements 10 erfasst und der Auswerteeinheit 4 bereitgestellt werden. Befindet sich der Verbraucher kurz vor einer thermischen Überlast, so liegt eine erhöhte Stromhöhe am ersten Messelement 10 vor. Durch eine Analyse der charakteristischen Erwärmung des ersten Messelementes 10 durch die Auswerteeinheit 4 kann somit ein Rückschluss auf den vorliegenden Zustand des nachgeschalteten Verbrauchers erfolgen. Hierfür ist in der Auswerteeinheit ein Referenzwert hinterlegt, welcher das Erwärmungsverhalten des ersten Messelements 10 bei einer anstehenden Überlast des nachgeschalteten Verbrauchers charakterisiert. Im Nennbetrieb liegt üblicherweise eine Temperatur von ca. 60 bis 100°C am ersten Messelement 10 vor. Kommt es jedoch zu einer Überlast am Verbraucher, so kann durch den erhöhten Stromfluss eine Temperatur am ersten Messelement 10 von bis zu 700°C vorliegen.

Durch eine Überwachung der Temperatur des ersten Messelementes 10 kann somit eine anstehende Überlast des Verbrauchers detektiert werden. In diesem Ausführungsbeispiel umfasst die Temperaturmesseinheit 18 hierfür drei Temperaturfühler 11,12,13. Eine Ausführungsform mit lediglich zwei Temperaturfühlern oder mehr als drei Temperaturfühlern je Temperaturmesseinheit ist ebenso denkbar. Der erste, zweite und dritte Temperaturfühler 11,12,13 ist maximal 2 mm von dem ersten Messelement 10 beabstandet und kann jeweils eine Temperatur eines spezifischen Messpunkts des ersten Messelements 10 erfassen. Hierbei werden durch die drei Temperaturfühler 11, 12,13 nicht die gleichen Messpunkte am ersten Messelement 10 detektiert. Zwischen den drei Temperaturfühlern 11,12,13 und dem ersten Messelement 10 ist eine elektrisch isolierende Isolationsschicht 51 angeordnet, so dass eine galvanische Trennung zwischen dem ersten Messelement und den drei Temperaturfühlern 11,12,13 sichergestellt ist. Die drei Temperaturfühler 11,12,13 sind hierbei gemeinsam auf der elektrisch isolierenden Isolationsschicht 51 befestigt.

Zur Ermittlung des vorliegenden Erwärmungsverhaltens des ersten Messelements 10 ist der erste, zweite und dritte Temperaturfühler 11,12,13 derart gegenüber dem ersten Messelement 10 angeordnet, dass Temperaturen von drei unterschiedlichen Messpunkten einer ersten Seitenfläche 6 des ersten Messelements 10 erfasst werden können. Diese Messpunkte sind jeweils derart über die erste Seitenfläche 6 verteilt, dass durch eine gleichzeitige Ermittlung der Temperaturen der drei Messpunkte mittels der drei Temperaturfühler 11,12,13 ein strombedingtes charakteristisches Erwärmungsverhalten des ersten Messelements 10 ermittelbar ist.

Der Messpunkt des ersten und dritten Temperaturfühlers 11,13 ist insbesondere im Randbereich der Längsachse der Seitenfläche 6 des ersten Messelements 10 angeordnet, wohingegen der Messpunkt des zweiten Temperaturfühlers 12 im Zentrum Längsachse der Seitenfläche 6 des ersten Messelements 10 liegt.

Im aktiven Betrieb des Verbrauchers liegt am ersten Messelement 10 ein Stromfluss vor. In Abhängigkeit des Stromflusses und der Stromflusszeit weist das erste Messelement 10 ein strombedingtes charakteristisches Erwärmungsverhalten auf. Im bestromten Zustand des ersten Messelements 10 ist insbesondere die durch den zweiten Temperaturfühler ermittelte Temperatur des zentralen Messpunkts an der Seitenfläche 6 gegenüber den Temperaturen der beiden Messpunkte im Randbereich erhöht. In Abhängigkeit der Stromhöhe und der Stromflusszeit nimmt das erste Messelement 10 folglich eine charakteristische Temperatur ein, welche über den Gesamtkörper des ersten Messelements 10 unterschiedlich ausgebildet sein kann. Es liegt somit in Abhängigkeit der Stromhöhe und der Stromflusszeit am ersten Messelement 10 ein charakteristisches Erwärmungsverhalten des erste Messelements 10 vor. Durch die gleichzeitige Ermittlung der Temperaturen der drei Messpunkte am ersten Messelement 10 und einem Abgleich der ermittelten Temperaturen in der Auswerteeinheit mit einem Referenzwert kann somit ein Rückschluss auf den Betriebszustand des nachgeschalteten Verbrauchers erfolgen, so dass eine anstehende Überlast ermittelt werden kann.

Dadurch, dass insbesondere das strombedingte Erwärmungsverhalten des ersten Messelements 10 durch die Temperaturmesseinheit erfasst wird, können insbesondere externe Störgrößen (innere und äußere Fremdheizquellen) weitestgehend kompensiert werden.

Die Seitenfläche 6 des ersten Messelements 10 weist insbesondere eine Größe von unter 10 cm$^2$ auf.

Der erste, zweite und dritte Temperaturfühler 11,12,13 ist jeweils ein Halbleiter, insbesondere eine Diode, so dass über eine Messung deren Spannung ein Rückschluss auf die vorliegende Temperatur des entsprechenden Messpunktes am ersten Messelement gewonnen werden kann.

Die ermittelten Temperaturen des ersten, zweiten und dritten Temperaturfühlers 11,12,13 werden der Auswerteeinheit 4 bereitgestellt, so dass diese das vorliegende Erwärmungsverhalten des ersten Messelements 10 ermitteln kann. Mittels der Temperaturfühler 11,12,13 kann insbesondere jeweils ein Temperaturunterschied von ca. 4 Kelvin im Bereich von -10°C bis 200°C ermittelt werden.

Das erste Messelement 10 ist ein metallischer elektrischer Widerstand (Shunt), welcher ein charakteristisches Erwärmungsverhalten aufweist. Der Auswerteeinheit 4 liegt das charakteristische Erwärmungsverhalten des ersten Messelementes 10 als Referenzwert vor, so dass sie anhand eines Vergleichs der ermittelten vorliegenden Temperatur des ersten Messelements 10 und somit des Erwärmungsverhaltens des ersten Messelements 10 mit dem in der Auswerteeinheit 4 hinterlegten Referenzwert einen Rückschluss auf den vorliegenden Auslastungszustand (Normalbetrieb / anstehende Überlast) des Verbrauchers gewinnen kann. Die Auswerteeinheit 4 kann folglich fortlaufend einen die Stromhöhe und Stromflusszeit charakterisierenden Wert überwachen, so dass anhand des vorliegenden Erwärmungsverhaltens des ersten Messelementes 10 und somit anhand dessen thermischen Zustandes ein Motor bzw. Leitungsschutz abgeleitet werden kann. Es kann somit überwacht werden, ob eine Überlast am nachgeschalteten Verbraucher ansteht oder nicht.

In der FIG 1 wird lediglich eine Phase durch die Überwachungseinrichtung überwacht. Es ist jedoch ebenso denkbar, dass bei mehrphasigen Verbrauchern jede Phase oder zumindest zwei Phasen jeweils eine Temperaturmesseinheit umfasst/-en.

Die Temperaturfühler 11,12 können die Temperaturunterschiede mit einer hohen Auflösung, beispielsweise ca. 4 Kelvin, messen. Auf diese Weise kann mit geringen Temperaturunterschieden und somit mit geringen elektrischen Widerstandswerten des erstens Messelements 10 gearbeitet werden. Hierdurch kann der Messbereich hinsichtlich der Stromuntergrenze $I_U$ erheblich nach unten vergrößert werden, so dass der Einstellbereich beispielsweise gegenüber der Bimetalllösung erheblich erweitert werden kann. Ein typischer Wert für die notwendige Temperatur bei Bimetalllösungen ist beispielsweise 60 Kelvin Übertemperatur. Währenddessen bei einer Lösung mittels eines ersten Messelementes 10 eine strombedingte Erwärmungen von bereits 4 Kelvin ermittelbar ist. Hiermit lassen sich Einstellbereich größer 1 zu 4 realisieren.

Die Erwärmung des ersten Messelements 10 ist weitgehend frequenzunabhängig und somit für AC- und DC-Anwendungen tauglich.

FIG 2 zeigt eine schematische Darstellung einer Vorrichtung 1 zum Schutz eines elektrischen Verbrauchers 2. Die Vorrichtung 1 ist in diesem Ausführungsbeispiel ein Überlastrelais 1, mit welchem ein Verbraucher 2, nämlich ein dreiphasiger elektrischer Motor, überwacht werden kann. Das Überlastrelais 1 ist hierfür in den Versorgungsstrang des Verbrauchers 2 zwischengeschaltet, so dass mittels des Überlastrelais 1 die drei Phasen des Verbrauchers 2 überwacht werden können.

Damit das Überlastrelais 1 in den Versorgungsstrang des elektrischen Verbrauchers 2 integriert werden kann, weist es eingangsseitige Anschlussvorrichtungen 106,206,306 und ausgangsseitige Anschlussvorrichtungen 107,207,307 auf. In dem Überlastrelais 1 werden die einzelnen Phasen des Verbrauchers 2 galvanisch getrennt geführt. Über die erste Strombahn wird die erste Phase, über die zweite Strombahn wird die zweite Phase und über die dritte Strombahn wird die dritte Phase des Verbrauchers 2 geführt. Die erste, zweite und dritte Strombahn sowie dessen Überwachungseinrichtung ist jeweils entsprechend der in der Figur 1 dargestellten und beschriebenen Ausführungsform ausgebildet. Lediglich die Auswerteeinheit 4 wurde zusammengefasst. Es ist aber ebenso denkbar, dass je Strombahn eine separate Auswerteeinheit 4 vorliegt.

Das Überlastrelais 1 weist eine Überwachungseinrichtung auf, mit welcher eine anstehende Überlast des elektrischen Verbrauchers 2 detektiert werden kann. Hierfür umfasst die erste Strombahn, wie bereits in FIG 1 gezeigt, eine erste Leitung 101 und eine zweite Leitung 102. Zwischen der ersten Leitung 101 und der zweiten Leitung 102 ist ein erstes Messelement 10 angeordnet, welches eine elektrische Verbindung zwischen den beiden Leitungen 101 und 102 herstellen. Das erste Messelement 10 ist insbesondere ein metallischer, elektrischer Widerstand. In Abhängigkeit der vorliegenden Stromhöhe und Stromflusszeit in der ersten Strombahn 100 liegt ein definiertes Erwärmungsverhalten des ersten Messelementes 10 vor.

Die Temperatur des ersten Messelementes 10 kann mittels eines ersten, zweiten und dritten Temperaturfühlers 11,12,13 einer ersten Temperaturmesseinheit gleichzeitig erfasst werden. Die gleichzeitig erfasste Temperatur der Temperaturfühler 11,12, 13 der ersten Temperaturmesseinheit wird der Auswerteeinheit 4 bereitgestellt. Eine elektrisch isolierende Schicht 51 zwischen dem ersten Messelement 10 und den Temperaturfühlern 11,12,13 stellt eine galvanische Trennung zwischen den Temperaturfühlern 11,12,13 und dem ersten Messelement 10 her und dient als Trägermaterial der Temperaturfühler 11,12,13.

Die Energieversorgung der zweiten Phase des Verbrauchers 2 wird über die zweite Strombahn geführt. Die zweite Strombahn weist eine erste Leitung 201 und eine zweite Leitung 202 auf. Zwischen der ersten und zweiten Leitung 201 und 202 ist ein zweites Messelement 20 angeordnet, welches eine elektrische Verbindung zwischen der ersten Leitung 201 und der zweiten Leitung 202 sicherstellt. Das zweite Messelement 20 ist ebenso wie das erste Messelement 10 der ersten Strombahn ein definierter Widerstand, welcher in Abhängigkeit des vorliegenden Stromflusses und der vorliegenden Stromflusszeit einen charakteristischen thermischen Zustand einnimmt. Die Temperaturverteilung am zweiten Messelement 20 kann mittels einer zweiten Temperaturmesseinheit ermittelt werden. Die zweite Temperaturmesseinheit umfasst hierfür einen ersten, zweiten und dritten Temperaturfühler 21,22,23. Die Temperaturfühler 21,22,23 der zweiten Temperaturmesseinheit sind ebenso mittels einer elektrisch isolierenden Isolationsschicht 52 galvanisch von dem zweiten Messelement 20 getrennt. Durch eine Abgleich der zeitgleich erfassten Temperaturen der Temperaturfühler 21,22,23 der zweiten Temperaturmesseinheit mit einem in der Auswerteeinheit 4 hinterlegten Referenzwert, welcher eine Anstehende eine Überlast charakterisierendes thermisches Verhalten des zweiten Messelements 20 charakterisiert, kann die Auswerteeinheit 4 den vorliegenden strombedingten thermischen Zustand des zweiten Messelements ermitteln und somit eine anstehende Überlast am Verbraucher detektieren.

Die Energieversorgung der dritten Phase des Verbrauchers 2 wird über die dritte Strombahn geführt, so dass die dritte Phase auf Überlast überwacht werden kann. Die dritte Strombahn weist eine erste Leitung 301 und eine zweite Leitung 302 auf. Zwischen der ersten und zweiten Leitung 301,302 ist ein drittes Messelement 30 angeordnet, welches die erste und zweite Leitung 301,302 elektrisch leitend verbindet. Ein über die dritte Strombahn fließender Strom fließt folglich über das dritte Messelement 30. In Abhängigkeit der Stromhöhe und der Stromflusszeit an der dritten Phase liegt ein charakteristisches strombedingtes Erwärmungsverhalten am dritten Messelement 30 vor. Zur Ermittlung des strombedingten Erwärmungsverhaltens wird die Temperatur des dritten Messelements 30 an drei Messpunkten mittels drei Temperaturfühler 31,32,33 gleichzeitig erfasst. Die erfasste Temperatur wird der Auswerteeinheit 4 zur weiteren Analyse bereitgestellt. Zwischen den Temperaturfühlern 31,32,33 und dem dritten Messelements 30 ist eine elektrisch isolierende Schicht 53 angeordnet, so dass eine galvanische Trennung der dritten Temperaturmesseinheit von dem dritten Messelement 30 erfolgt.

Die einzelnen Strombahnen weisen folglich jeweils ein Messelement 10,20,30 auf, welches in Abhängigkeit der anliegenden Stromhöhe und der Stromflusszeit eine charakteristische strombedingte Erwärmung vollzieht. Anhand einer Überwachung des strombedingten thermischen Verhaltens der jeweiligen Messelemente 10,20,30 und eines Vergleichs mit dem hinterlegten Referenzwert kann ein Rückschluss auf den vorliegenden Stromfluss in der entsprechenden Strombahn und somit ein Rückschluss auf den vorliegenden Betriebszustand des Verbrauchers 2 gewonnen werden, so dass eine anstehende Überlast am Verbraucher 2 durch die Auswerteeinheit 4 abgeleitet werden.

Das erste, zweite und dritte Messelement 10,20,30 sowie die erste, zweite und dritten Temperaturmesseinheit ist jeweils baugleich ausgebildet. Die Auswertung der ermittelten Temperaturen der ersten, zweiten und dritten Temperaturmesseinheit kann folglich einheitlich erfolgen.

Der Auswerteeinheit 4 ist die Erwärmungscharakteristik des ersten, zweiten und dritten Messelementes 10,20,30 bekannt und als Referenzwert hinterlegt, so dass die Auswerteeinheit 4 durch einen Abgleich der ermittelten Temperaturen der ersten, zweiten und/oder dritten Temperaturmesseinheit mit dem Referenzwert eine anstehende Überlast des elektrischen Verbrauchers 2 ermitteln kann. Bei einer ermittelten anstehenden Überlast des Verbrauchers 2 gibt die Auswerteeinheit 4 ein Warnsignal aus, so dass nicht abgebildete Schaltelemente des Verbrauchers 2 geschaltet werden und somit der Energiefluss zum Verbraucher 2 unterbunden wird. Auf diese Weise kann eine thermische Beschädigung des Verbrauchers 2 hinsichtlich einer Überlast durch die Vorrichtung 1 vermieden werden.

Dadurch, dass eine thermische Überlast des Verbrauchers 2 durch eine Erwärmung des Messelements 10,20,30 ermittelt wird, liegt ebenso ein thermisches Gedächtnis durch das Messelement 10,20,30 vor, so dass es kurz nach einer thermischen Überlast nicht versehentlich zu einem Zuschalten des Verbrauchers kommen kann. Erst nachdem das Messelement 10,20,30 eine definierte Abkühlung erfahren hat, kann der Verbraucher 2 erneut an das Versorgungsnetz geschaltet werden, so dass dieser wieder mit Strom versorgt wird. Die Ermittlung der notwendigen Abkühlung des Verbrauchers erfolgt durch eine Analyse der Temperaturen der Messelemente 10,20,30. Hierfür wird seitens der jeweiligen Temperaturmesseinheit die Temperatur des betroffenen Messelements 10,20,30 ermittelt und seitens der Auswerteeinheit 4 ausgewertet. Hierfür liegend der Auswerteeinheit 4 ebenso Abkühlungsreferenzwerte vor.

Die Vorrichtung 1 zur Überwachung einer thermischen Überlast eines Verbrauchers 2 wurde in FIG 2 beispielhaft anhand eines Überlastrelais 1 beschrieben. Ebenso kann die Vorrichtung 1 beispielsweise ein Leistungsschalter (z.B. Motorschutzschalter, Anlagenschutzschalter) sein.

Die Temperaturfühler 11,12,13,21,22,23,31,32,33 sind jeweils Halbleiter, insbesondere Dioden, so dass mittels einer Analyse deren Spannung die Temperatur am Temperaturfühler und somit am zugehörigen Messpunkt des entsprechenden Messelements 10,20,30 ermittelt werden kann. Zur Steigerung der Messgenauigkeit können ebenso mehrere Temperaturfühler an den Messelementen 10,20,30 platziert werden. Ebenso ist es denkbar, dass je Messelement 10,20,30 lediglich zwei Temperaturfühler platziert sind.

Als Verbraucher 2 kann ebenso eine Leitung gesehen werden, bei welcher ein Schutz vor einer thermischen Überlast sichergestellt werden muss.

Ein großer Vorteil der Vorrichtung 1 und insbesondere der Überwachungseinrichtung besteht darin, dass die galvanische Trennung zwischen den einzelnen Phasen sowie der jeweiligen Temperaturfühler 11,12,13,21,22,23,31,32,33 zu den entsprechenden Strombahnen leicht zu realisieren ist.

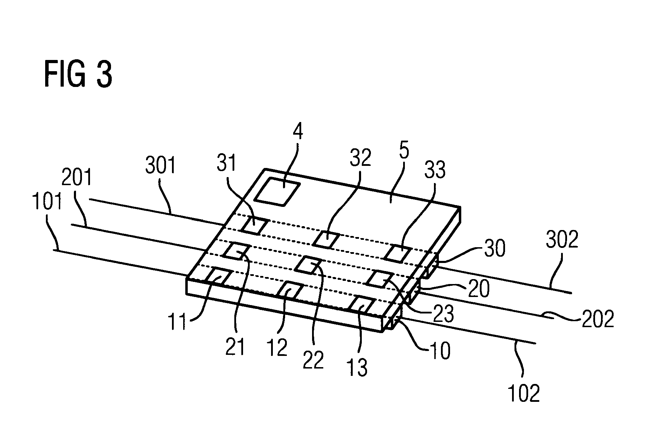

FIG 3 zeigt eine schematische Darstellung einer Vorrichtung zum Schutz eines elektrischen Verbrauchers, wobei eine Überwachungseinrichtung auf einer Leiterplatte 5 aufgebracht ist. Im Unterschied zur Überwachungseinrichtung gemäß Figur 2 sind hierbei die erste, zweite und dritte Temperaturmesseinheit sowie die Auswerteeinheit 4 auf einer Oberseite einer einzigen Leiterplatte 5 montiert und die Messeinheiten 10,20,30 auf der Unterseite der Leiterplatte 5 montiert.

Das erste Messelement 10 ist auf der Unterseite der Leiterplatte 5 montiert und ist eingangsseitig mit einer Leitung 101 und ausgangsseitig mit einer Leitung 102 verbunden. Über diese erste Strombahn erfolgt die Energieversorgung eines nachgeschalteten Verbrauchers (erste Phase).

Das zweite Messelement 20 ist ebenso auf der Unterseite der Leiterplatte 5 montiert und ist eingangsseitig mit einer Leitung 201 und ausgangsseitig mit einer Leitung 202 verbunden. Über diese zweite Strombahn erfolgt die Energieversorgung des nachgeschalteten Verbrauchers (zweite Phase).

Das dritte Messelement 30 ist ebenso auf der Unterseite der Leiterplatte 5 montiert und ist eingangsseitig mit einer Leitung 301 und ausgangsseitig mit einer Leitung 302 verbunden.

Über diese dritte Strombahn erfolgt die Energieversorgung des nachgeschalteten Verbrauchers (dritte Phase).

Auf der Oberseite (die den Messelementen 10,20,30 abgewandte Seite) der Leiterplatte 5 ist die erste, zweite und dritte Temperaturmesseinheit und die Auswerteeinheit 4 montiert. Durch die Leiterplatte erfolgt eine galvanische Trennung zwischen der ersten, zweiten und dritten Temperaturmesseinheit und der Auswerteeinheit 4 gegenüber den Messelementen 10,20,30.

Die erste Temperaturmesseinheit umfasst drei Temperaturfühler 11,12,13, wobei zwei Temperaturfühler 11,13 im Randbereich (Anfang und Ende) der Längsachse einer Seitenfläche des ersten Messelements 10 angeordnet sind und ein Temperaturfühler 12 im Zentrum der Längsachse der Seitenfläche des ersten Messelements 10 angeordnet ist. Auf diese Weise kann eine Temperaturdifferenzwert ($\Delta T_n$) des ersten Messelements 10 ermittelt werden.

Die zweite Temperaturmesseinheit umfasst drei Temperaturfühler 21,22,23, wobei zwei Temperaturfühler 21,23 im Randbereich (Anfang und Ende) der Längsachse einer Seitenfläche des zweiten Messelements 20 angeordnet sind und ein Temperaturfühler 22 im Zentrum der Längsachse der Seitenfläche des zweiten Messelements 20 angeordnet ist. Auf diese Weise kann eine Temperaturdifferenzwert ($\Delta T_n$) des zweiten Messelements 20 ermittelt werden.

Die Temperaturfühler 31,32,33 der dritten Temperaturmesseinheit sind gegenüber dem dritten Messelement 30 äquivalent wie die Temperaturfühler der ersten Temperaturmesseinheit gegenüber dem ersten Messelements 10 angeordnet.

Dadurch, dass die Temperaturfühler 11,12,13,21,22,23,31,32,33 bezüglich der Messelemente 10,20,30 an der gegenüberliegenden Seitenfläche der Leiterplatte 5 angeordnet sind, wird erreicht, dass ein gute thermisch Kopplung zwischen den Temperaturfühlern 11,12,13,21,22,23,31,32,33 und den Messelementen 10,20,30 bei gleichzeitiger galvanischer Trennung vorliegt.

Je Temperaturmesseinheit kann somit anhand einer gleichzeitigen Ermittlung der Temperaturen der Temperaturfühler 11,12, 13,21,22,23,31,32,33 ein Temperaturdifferenzwert ($\Delta T_n$) berechnet werden. Dieser Temperaturdifferenzwert ($\Delta T_n$) wird vorzugsweise wie folgt berechnet:

$$\Delta T_n = \frac{(T_{n2} - T_{n1}) + (T_{n2} - T_{n3})}{2} = T_{n2} - \left(\frac{T_{n1} + T_{n3}}{2}\right)$$

$\Delta T_n$:     Temperaturdifferenzwert
$T_{n1}$     Ermittelte Temperatur des ersten Temperaturfühlers 11,21,31 am ersten Messpunkt
$T_{n2}$:     Ermittelte Temperatur des zweiten Temperaturfühlers 12,22,32 am zweiten Messpunkt
$T_{n3}$:     Ermittelte Temperatur des dritten Temperaturfühlers 13,23,33 am dritten Messpunkt
n:     Betrachtetes Messelement 10,20,30 und somit betrachtete Strombahn

Durch den berechneten Temperaturdifferenzwert $\Delta T_n$ der jeweiligen Temperaturmesseinheit wird das Erwärmungsverhalten des jeweiligen Messelements 10,20,30 ermittelt, so dass ein Rückschluss auf eine strombedingte Erwärmung des jeweiligen Messelements erfolgen kann. Der berechnete Temperaturdifferenzwert der jeweiligen Temperaturmesseinheit kann nun mit einem in der Auswerteeinheit hinterlegten Referenzwert (SOLL-Wert) verglichen werden, so dass ein eine Überlast am Verbraucher charakterisierender thermischer Zustand des jeweiligen Messelements 10,20,30 detektiert werden kann. Durch die Auswerteeinheit 4 kann somit zu jedem Auswertezeitpunkt ein Vergleich des ermittelten Temperaturdifferenzwerts $\Delta T_n$ (IST-Wert) mit dem Referenzwert (SOLL-Wert) erfolgen. Ist der ermittelte Temperaturdifferenzwerts $\Delta T_n$ größer als der Referenzwert (SOLL-Wert), so liegt eine anstehende Überlast am Verbraucher vor. In der Auswerteeinheit 4 kann ferner ein Schwellwert hinterlegt sein, so dass eine vorliegende Überlast am Verbraucher detektiert wird.

Alternativ hierzu kann ebenso zur Ermittlung einer anstehenden Überlast am Verbraucher eine Auswertung des Temperaturdifferenzwerts $\Delta T_n$ mittels eines Integrationsverfahrens erfolgen. Hierbei werden innerhalb eines Integrationsintervalls die Temperaturdifferenzwerte $\Delta T_n$ einer jeweiligen Temperaturmesseinheit aufsummiert, so dass als Gesamtsumme $\Delta T_{Sum}$ gebildet wird. $\Delta T_{Sum}$ ist folglich die Summenbildung des Temperaturdifferenzwerte $\Delta T_n$ über den Zeitraum des Integrationsintervalls. Die Gesamtsumme $\Delta T_{Sum}$ bildet folglich denjenigen Wärmeeintrag ab, den das entsprechende Messelement 10,20,30 während des Integrationsintervalls $t_{integr}$ erfahren hat.

Nach folgender Formel wird hierbei der Temperaturdifferenzwert $\Delta T_n$ zu den jeweiligen Auswertezeitpunkten in der Auswerteeinheit zur Gesamtsumme $\Delta T_{Sum}$ aussummiert.

$$\Delta T_{Sum} = \sum_{t=t_{Integr,Start}}^{t_{Integr,Ende}} \Delta T_n(dt)$$

$\Delta T_n$:     Ist der Temperaturdifferenzwerts des entsprechenden Messelements "n" 10,20,30 zum jeweiligen Auswertezeitpunkt, in welchem durch die entsprechende Temperaturmesseinheit gleichzeitig die Temperaturen erfasst werden.
n:     Betrachtetes Messelement 10,20,30 und somit betrachtete Strombahn
$t=t_{integr,Start}$:     Start des Integrationsintervalls
$t=t_{integr,Ende}$:     Ende des Integrationsintervalls

Als Referenzwert sind bezüglich obigen Auswerteprinzips SOLL-Werte in der Auswerteeinheit 4 hinterlegt, welche in Abhängigkeit des Integrationsintervalls $t_{integr}$ einen Normalbetrieb oder eine anstehende Überlast am Verbraucher charakterisieren. Je Integrationsintervall kann somit ein Vergleich des ermittelten IST-Wertes ($\Delta T_{Sum}$) mit dem SOLL-Wert (Referenzwert) erfolgen. Wird der SOLL-Wert (Referenzwert) durch den ermittelten IST-Wert überschritten so liegt eine anstehende Überlast am Verbraucher vor.

Der entsprechende SOLL-Wert ist beispielsweise in Tabellenform oder als Polynom-Formel in der Auswerteeinheit hinterlegt, so dass je Auswertezeitpunkt (Zeitpunkte des SOLL-IST-Vergleichs) ein spezifischer SOLL-Wert als Referenzwert vorliegt. Der SOLL-Wert kann hierbei insbesondere in Abhängigkeit der vorliegenden Stromflusszeit und Stromflusshöhe am entsprechenden Messelement 10,20,30 unterschiedlich sein. Ebenso kann vorzugsweise während der Analyse der Integrationsintervall variieren. In Abhängigkeit des vorliegenden Integrationsintervalls sind in der Auswerteeinheit entsprechende SOLL-Werte hinterlegt. Durch die SOLL-Werte wird vorzugsweise die Strom/Zeit-Auslösecharakteristik heutiger thermomechanischer Lösungen nachgebildet.

Eine weitere Auswertemethode kann durch eine Auswertung der Anstiegsgeschwindigkeit des Temperaturdifferenzwerts $\Delta T_n$ erfolgen. Hierbei wird der IST-Wert nach folgender Formel berechnet:

$$\left(\frac{d\Delta T_n}{dt}\right)_x = \frac{\Delta T_{nx} - \Delta T_{n(x-1)}}{t_x - t_{x-1}}$$

$\Delta T_n$:   Ist der Temperaturdifferenzwert des entsprechenden Messelements "n" 10,20,30 zum jeweiligen Auswertezeitpunkt, in welchem durch die entsprechende Temperaturmesseinheit gleichzeitig die Temperaturen erfasst werden.

n:   Betrachtetes Messelement 10,20,30 und somit betrachtete Strombahn

x:   Auswertezeitpunkt (aktueller Zeitpunkt der Messauswertung)

In der Auswerteeinheit ist als Referenzwert ein SOLL-Wert hinterlegt, welcher den Zeitpunkt (Auslösezeitpunkt) angibt, in welchem eine Überlast am Verbraucher ansteht. Der SOLL-Wert charakterisiert hierbei eine charakteristische Anstiegsgeschwindigkeit des Temperaturdifferenzwerts $\Delta T_n$, bei dessen Überschreitung eine Überlast am Verbraucher ansteht. Der entsprechende SOLL-Wert ist beispielsweise in Tabellenform oder als Polynom-Formel in der Auswerteeinheit hinterlegt, so dass je Auswertezeitpunkt (Zeitpunkte des SOLL-IST-Vergleichs) ein spezifischer SOLL-Wert als Referenzwert vorliegt.

Ebenso ist es denkbar, oben beschriebene Auswertemethoden (Auswertung des Temperaturdifferenzwerts, Auswertung nach dem Integrationsverfahren des Temperaturdifferenzwerts und Auswertung der Anstiegsgeschwindigkeit des Temperaturdifferenzwerts) als Auslösekriterium zu kombinieren.

So ist es denkbar, dass bei kleineren Auslösezeiten und höheren Motorströmen die "Auswertung der Anstiegsgeschwindigkeit des Temperaturdifferenzwerts" erfolgt und bei längeren Auslösezeiten und kleineren Motorströmen die "Auswertung des Temperaturdifferenzwerts" erfolgt.

Denkbar ist auch, das Integrationsintervall der "Auswertung nach dem Integrationsverfahren des Temperaturdifferenzwerts" in Abhängigkeit zur aktuellen "Anstiegsgeschwindigkeit des Temperaturdifferenzwerts" zu verändern.

Ferner ist es denkbar zusätzlich zu den beschriebenen Auswertemethoden eine Auswertung der absoluten Temperatur des jeweiligen Messelements 10,20,30 durchzuführen.

Die Bildung des Temperaturdifferenzwerts $\Delta T_n$ eines Mehrpunkt-Temperaturerfassungs-Systems bietet naturgemäß den Vorteil, gegenüber vielen Temperatureinflüssen unempfindlich zu sein. Starke, äußere Temperatureinflüsse können unter gewissen Umständen durch diese Mehrpunktmessung nicht mehr kompensiert werden. Deshalb kann es sinnvoll sein, die Auswertungs-Methoden durch eine Auswertung der absoluten Temperatur der Messelemente 10,20,30 zu ergänzen. Dadurch können beispielsweise starke, äußere Temperatureinflusse erkannt und bei Bedarf ergänzend zu den bereits beschriebenen Auswertungs-Methoden in der Auswerteeinheit 4 berücksichtigt werden.

Eine schnelle und starke Abkühlung der Zuleitung(en) 101,201, 301,102,202,302 kann zum Temperaturabfall eines oder mehrerer Temperatur-Messpunkte eines Mehrpunkt-Temperaturerfassungs-Systems führen. Hierbei sind insbesondere die Messpunkte betroffen, welche am geringsten zu den Leitungen 101,201,301, 102,202,302 der Strombahnen beabstandet sind. Bei einer alleinigen Auswertung des Temperaturdifferenzwerts $\Delta T_n$ wurde dies als Stromfluss durch das entsprechende Messelement 10, 20,30 interpretiert werden. Als Gegenmaßnahme könnte durch die Auswerteeinheit 4 eine Erhöhung des Temperaturdifferenzwerts $\Delta T_n$ durchgeführt werden.

Eine schnelle und starke Erwärmung der Zuleitung(en) 101,201, 301,102,202,302 kann zum Temperaturanstieg eines oder mehrerer Temperatur-Messpunkte eines Mehrpunkt-Temperaturerfassungs-Systems führen. Bei einer alleinigen Auswertung des Temperaturdifferenzwerts $\Delta T_n$ wurde dies als Abschalten des Stromflusses durch das entsprechende Messelement 10,20,30 interpretiert werden. Als Gegenmaßnahme könnte durch die Auswerteeinheit 4 eine Verkleinerung des Temperaturdifferenzwerts $\Delta T_n$ durchgeführt werden.

**Patentansprüche**

1. Vorrichtung (1), zum Schutz eines Verbrauchers (2), mit einer ersten Strombahn, welche zwei Leitungen (101,102) umfasst, und einer Überwachungseinrichtung, zur Ermittlung einer anstehenden Überlast des Verbrauchers (2), **dadurch gekennzeichnet, dass** die Überwachungseinrichtung eine erste Temperaturmesseinheit, eine Auswerteeinheit (4) und ein erstes Messelement (10), welches eine elektrisch leitende Verbindung zwischen den zwei Leitungen (101,102) der ersten Strombahn herstellt, umfasst, wobei die erste Temperaturmesseinheit von dem ersten Messelement (10) galvanisch getrennt ist und einen ersten und einen zweiten Temperaturfühler (11,12) umfasst, wobei der erste und zweite Temperaturfühler (11,12) der ersten Temperaturmesseinheit gleichzeitig jeweils eine Temperatur des ersten Messelements (10) erfassen kann und die Auswerteeinheit (4) anhand der erfassten Temperaturen der ersten Temperaturmesseinheit eine anstehende Überlast am Verbraucher (2) ermitteln kann.

2. Vorrichtung (1) nach Anspruch 1, wobei die erste Temperaturmesseinheit ferner einen dritten Temperaturfühler (13) umfasst, welcher gleichzeitig mit dem ersten und zweiten Temperaturfühler (11,12) der ersten Temperaturmesseinheit eine Temperatur des ersten Messelements erfassen kann.

3. Vorrichtung (1) nach Anspruch 2, wobei der erste, zweite und dritte Temperaturfühler (11,12,13) derart zum ersten Messelement (10) angeordnet ist, dass der erste Temperaturfühler (11) eine Temperatur an einem ersten Messpunkt des ersten Messelements (10) erfassen kann, der zweite Temperaturfühler (12) eine Temperatur an einem zweiten Messpunkt des ersten Messelements (10) erfassen kann und der dritte Temperaturfühler (13) eine Temperatur an einem dritten Messpunkt des ersten Messelements (10) erfassen kann, wobei im Bezug zu einer ersten Seitenfläche (6) des ersten Messelements (10) der zweite Messpunkt zwischen dem ersten und dritten Messpunkt auf der ersten Seitenfläche (6) liegt.

4. Vorrichtung (1) nach einem der vorhergehenden Ansprüche, wobei der jeweilige Temperaturfühler (11,12,13) maximal 2 mm von dem ersten Messelement (10) beabstandet ist.

5. Vorrichtung (1) nach einem der vorhergehenden Ansprüche, wobei zwischen den Temperaturfühlern (11,12,13) der ersten Temperaturmesseinheit und dem Messelement (10) eine elektrisch isolierende Isolationsschicht (5,51) angeordnet ist.

6. Vorrichtung (1) nach einem der vorhergehenden Ansprüche, mit einer zweiten Strombahn, welche zwei Leitungen (201,202) umfasst, wobei die Überwachungseinrichtung ferner eine zweite Temperaturmesseinheit und ein zweites Messelement (20), welches eine elektrisch leitende Verbindung zwischen den zwei Leitungen (201,202) der zweiten Strombahn herstellt, umfasst, wobei die zweite Temperaturmesseinheit von dem zweiten Messelement (20) galvanisch getrennt ist und einen ersten und einen zweiten Temperaturfühler (21,22) umfasst, wobei der erste und zweite Temperaturfühler (21,22) der zweiten Temperaturmesseinheit gleichzeitig jeweils eine Temperatur des zweiten Messelements (20) erfassen kann und die Auswerteeinheit (4) anhand der erfassten Temperaturen der zweiten Temperaturmesseinheit eine anstehende Überlast am Verbraucher (2) ermitteln kann.

7. Vorrichtung (1) nach Anspruch 6, wobei die zweite Temperaturmesseinheit ferner einen dritten Temperaturfühler (23) umfasst, welcher gleichzeitig mit dem ersten und zweiten Temperaturfühler (21,22) der zweiten Temperaturmesseinheit eine Temperatur des zweiten Messelements erfassen kann.

8. Vorrichtung (1) nach einem der vorhergehenden Ansprüche, mit einer dritten Strombahn, welche zwei Leitungen (301,302) umfasst, wobei die Überwachungseinrichtung ferner eine dritte Temperaturmesseinheit und ein drittes Messelement (30), welches eine elektrisch leitende Verbindung zwischen den beiden Leitungen (301,302) der dritten Strombahn herstellt, umfasst, wobei die dritte Temperaturmesseinheit von dem dritten Messelement (30) galvanisch getrennt ist und einen ersten und einen zweiten Temperaturfühler (31,32) umfasst, wobei der erste und zweite Temperaturfühler (31,32) der dritten Temperaturmesseinheit gleichzeitig jeweils eine Temperatur des dritten Messelements (30) erfassen kann und die Auswerteeinheit (4) anhand der erfassten Temperaturen der dritten Temperaturmesseinheit eine anstehende Überlast am Verbraucher (2) ermitteln kann.

9. Vorrichtung (1) nach Anspruch 8, wobei die dritte Temperaturmesseinheit ferner einen dritten Temperaturfühler (33) umfasst, welcher gleichzeitig mit dem ersten und zweiten Temperaturfühler (31,32) der dritten Temperaturmesseinheit eine Temperatur des ersten Messelements erfassen kann.

10. Vorrichtung (1) nach einem der vorhergehenden Ansprüche, wobei der jeweilige Temperaturfühler (11,12,13,21,22,23,31,32,33) ein Halbleiter, insbesondere eine Diode, ist.

11. Vorrichtung (1) nach einem der vorhergehenden Ansprüche, wobei die Vorrichtung (1) ein Schaltgerät, insbesondere ein Überlastrelais oder ein Leistungsschalter, ist.

12. Verfahren zum Schutz eines Verbrauchers (2), wobei eine Vorrichtung (1) eine erste Strombahn, welche zwei Leitungen (101,102) umfasst, und eine Überwachungseinrichtung, zur Ermittlung einer anstehenden Überlast des Verbrauchers (2), umfasst,
**dadurch gekennzeichnet, dass** die Überwachungseinrichtung eine erste Temperaturmesseinheit, eine Auswerteeinheit (4) und ein erstes Messelement (10), welches eine elektrisch leitende Verbindung zwischen den zwei Leitungen (101,102) der ersten Strombahn herstellt, umfasst, wobei die erste Temperaturmesseinheit von dem ersten Messelement (10) galvanisch getrennt ist und einen ersten und einen zweiten Temperaturfühler (11,12) umfasst, wobei der erste und zweite Temperaturfühler (11,12) gleichzeitig jeweils eine Temperatur des ersten Messelements (10) erfasst und die Auswerteeinheit (4) anhand der erfassten Temperaturen der ersten Temperaturmesseinheit eine anstehende Überlast am Verbraucher (2) ermittelt.

13. Verfahren nach Anspruch 12, wobei die Auswerteeinheit (4) anhand der gleichzeitig erfassten Temperaturen der ersten Temperaturmesseinheit eine strombedingte Erwärmung des ersten Messelements (10) ermittelt.

**Claims**

1. Device (1) for protecting a load (2) with a first current path having two lines (101, 102), and a monitoring arrangement for detecting an imminent overload on the load (2), **characterised in that**
the monitoring arrangement comprises a first temperature measuring unit, an evaluation unit (4) and a first measuring element (10) which creates an electrically conductive connection between the two lines (101, 102) of the first current path, wherein the first temperature measuring unit is electrically isolated from the first measuring element (10) and comprises a first and a second temperature sensor (11, 12), wherein the first and second temperature sensors (11, 12) of the first temperature measuring unit can each detect a temperature of the first measuring element (10) simultaneously and the evaluation unit (4) can detect, based on the detected temperatures of the first temperature measuring unit, an imminent overload on the load (2).

2. Device (1) according to claim 1, wherein the first temperature measuring unit also comprises a third temperature sensor (13), which can detect a temperature of the first measuring element simultaneously with the first and second temperature sensors (11, 12) of the first temperature measuring unit.

3. Device (1) according to claim 2, wherein the first, second and third temperature sensors (11, 12, 13) are arranged relative to the first measuring element (10) such that the first temperature sensor (11) can detect a temperature at a first measuring point of the first measuring element (10), the second temperature sensor (12) can detect a temperature at a second measuring point of the first measuring element (10) and the third temperature sensor (13) can detect a temperature at a third measuring point of the first measuring element (10), wherein in relation to a first side face (6) of the first measuring element (10), the second measuring point lies between the first and third measuring points on the first side face (6).

4. Device (1) according to one of the preceding claims, wherein each temperature sensor (11, 12, 13) is spaced a maximum of 2 mm apart from the first measuring element (10).

5. Device (1) according to one of the preceding claims, wherein an electrically isolating insulating layer (5, 51) is arranged between the temperature sensors (11, 12, 13) of the first temperature measuring unit and the measuring element (10).

6. Device (1) according to one of the preceding claims, having a second current path which comprises two lines (201, 202), wherein the monitoring arrangement also comprises a second temperature measuring unit and a second measuring element (20) which creates an electrically conductive connection between the two lines (201, 202) of the second current path, wherein the second temperature measuring unit is electrically isolated from the second measuring element (20) and comprises a first and a second temperature sensor (21, 22), wherein the first and second temperature sensors (21, 22) of the second temperature measuring unit can detect a temperature of the second measuring element (20) simultaneously and the evaluation unit (4) can detect, based on the detected temperatures of the second temperature measuring unit, an imminent overload on the load (2).

7. Device (1) according to claim 6, wherein the second temperature measuring unit also comprises a third temperature sensor (23), which can detect a temperature of the second measuring element simultaneously with the first and second temperature sensors (21, 22) of the second temperature measuring unit.

8. Device (1) according to one of the preceding claims, having a third current path which comprises two lines (301, 302), wherein the monitoring arrangement also comprises a third temperature measuring unit and a third measuring element (30) which creates an electrically conductive connection between the two lines (301, 302) of the third current path, wherein the third temperature measuring unit is electrically isolated from the third measuring element (30) and comprises a first and a second temperature sensor (31, 32), wherein the first and second temperature sensors (31, 32) of the third temperature measuring unit can each detect a temperature of the third measuring element (30) simultaneously and the evaluation unit (4) can detect, based on the detected temperatures of the third temperature measuring unit, an imminent overload on the load (2).

9. Device (1) according to claim 8, wherein the third temperature measuring unit also comprises a third temperature sensor (33) which can detect a temperature of the first measuring element simultaneously with the first and second temperature sensors (31, 32) of the third temperature measuring unit.

10. Device (1) according to one of the preceding claims, wherein the respective temperature sensor (11, 12, 13, 21, 22, 23, 31, 32, 33) is a semiconductor, in particular a diode.

11. Device (1) according to one of the preceding claims, wherein the device (1) is a switching device, in particular an overload relay or a circuit breaker.

12. Method for protecting a load (2), wherein a device (1) has a first current path having two lines (101, 102), and a monitoring arrangement for detecting an imminent overload on the load (2),
**characterised in that**
the monitoring arrangement comprises a first temperature measuring unit, an evaluation unit (4) and a first measuring element (10) which creates an electrically conductive connection between the two lines (101, 102) of the first current path, wherein the first temperature measuring unit is electrically isolated from the first measuring element (10) and comprises a first and a second temperature sensor (11, 12), wherein the first and second temperature sensors (11, 12) can each detect a temperature of the first measuring element (10) simultaneously and the evaluation unit (4) can detect, based on the detected temperatures of the first temperature measuring unit, an imminent overload on the load (2).

13. Method according to claim 12, wherein the evaluation unit (4) detects current-related heating of the first measuring element (10) by means of the simultaneously detected temperatures of the first temperature measuring unit.

**Revendications**

1. Montage ( 1 ) de protection d'un consommateur ( 2 ), comprenant une première voie de courant qui comprend deux lignes ( 101, 102 ), et un dispositif de contrôle pour la détermination d'une surcharge imminente du consommateur ( 2 ), **caractérisé en ce que**
le dispositif de contrôle comprend une première unité de mesure de la température, une unité ( 4 ) d'exploitation et un premier élément ( 10 ) de mesure, qui ménage une liaison conductrice de l'électricité entre les deux lignes ( 101, 102 ) de la première voie de courant, la première unité de mesure de la température étant séparée galvaniquement du premier élément ( 10 ) de mesure et comprenant une première et une deuxième sondes ( 11, 12 ) de température, la première et la deuxième sondes ( 11, 12 ) de température de la première unité de mesure de la température pouvant détecter en même temps respectivement une température du premier élément ( 10 ) de mesure et l'unité ( 4 ) d'exploitation pouvant, à l'aide des températures détectées de la première unité de mesure de la température, déterminer une surcharge imminente du consommateur ( 2 ).

2. Montage ( 1 ) suivant la revendication 1, dans lequel la première unité de mesure de la température comprend en outre une troisième sonde ( 13 ) de température, qui peut détecter, en même temps que la première et la deuxième sondes ( 11, 12 ) de température de la première unité de mesure de la température, une température du premier élément de mesure.

**3.** Montage ( 1 ) suivant la revendication 2, dans lequel la première, deuxième et troisième sondes ( 11, 12, 13 ) de température sont disposées par rapport au premier élément ( 10 ) de mesure de manière à ce que la première sonde de température puisse détecter une température en un premier point de mesure du premier élément ( 10 ) de mesure, que la deuxième sonde ( 12 ) de température puisse détecter une température en un deuxième point de mesure du premier élément ( 10 ) de mesure et que la troisième sonde ( 13 ) puisse détecter une température en un troisième point de mesure du premier élément ( 10 ) de mesure, le deuxième point de mesure se trouvant par rapport à une première surface ( 6 ) latérale du premier élément ( 10 ) de mesure entre le premier et le troisième points de mesure sur la première surface ( 6 ) latérale.

**4.** Montage ( 1 ) suivant l'une des revendications précédente, dans lequel la sonde ( 11, 12, 13 ) de température respective est à une distance au maximum de 2 mm du premier élément ( 10 ) de mesure.

**5.** Montage ( 1 ) suivant l'une des revendications précédentes, dans lequel une couche ( 5, 51 ) isolante du point de vue électrique est disposée entre les sondes ( 11, 12, 13 ) de température de la première unité de mesure de la température et l'élément ( 10 ) de mesure.

**6.** Montage ( 1 ) suivant l'une des revendications précédentes, comprenant une deuxième voie de courant, qui comprend deux lignes ( 201, 202 ), le dispositif de contrôle comprenant en outre une deuxième unité de mesure de la température et un deuxième élément ( 20 ) de mesure qui ménage une liaison conductrice de l'électricité entre les deux lignes ( 201, 202 ) de la deuxième voie de courant, la deuxième unité de mesure de la température étant séparée galvaniquement du deuxième élément ( 20 ) de mesure et comprenant une première et une deuxième sondes ( 21, 22 ) de température, la première et la deuxième sondes ( 21, 22 ) de température de la deuxième unité de mesure de la température pouvant détecter en même temps respectivement une température du deuxième élément ( 20 ) de mesure et l'unité ( 4 ) d'exploitation pouvant déterminer, au moyen des températures détectées de la deuxième unité de mesure de la température, une surcharge imminente du consommateur ( 2 ).

**7.** Montage ( 1 ) suivant la revendication 6, dans lequel la deuxième unité de mesure de la température comprend en outre une troisième sonde ( 23 ) de température qui peut, en même temps que la première et la deuxième sondes ( 21, 22 ) de température de la deuxième unité de mesure de la température, détecter une température du deuxième élément de mesure.

**8.** Montage ( 1 ) suivant l'une des revendications précédentes, comprenant une troisième voie de courant, qui comprend deux lignes ( 301, 302 ), le dispositif de contrôle comprenant en outre une troisième unité de mesure de la température et un troisième élément ( 30 ) de mesure qui ménage une liaison conductrice de l'électricité entre les deux lignes ( 301, 302 ) de la troisième voie de courant, la troisième unité de mesure de température étant séparée galvaniquement du troisième élément ( 30 ) de mesure et comprenant une première et une deuxième sondes ( 31, 32 ) de température, la première et la deuxième sondes ( 31, 32 ) de température de la troisième unité de mesure de la température pouvant détecter en même temps respectivement une température du troisième élément ( 30 ) de mesure et l'unité ( 4 ) d'exploitation pouvant détecter, au moyen des températures détectées de la troisième unité de mesure de la température, une surcharge imminente du consommateur ( 2 ).

**9.** Montage ( 1 ) suivant la revendication 8, dans lequel la troisième unité de mesure de la température comprend en outre une troisième sonde ( 33 ) de température qui peut, en même temps que la première et la deuxième sondes ( 31, 32 ) de température de la troisième unité de mesure de la température, détecter une température du premier élément de mesure.

**10.** Montage ( 1 ) suivant l'une des revendications précédentes, dans lequel la sonde ( 11, 12, 13, 21, 22, 23, 31, 32, 33 ) de température respective est un semi-conducteur, notamment une diode.

**11.** Montage ( 1 ) suivant l'une des revendications précédentes, dans lequel le montage ( 1 ) est un appareil de coupure, notamment un relais de surcharge ou un disjoncteur.

**12.** Procédé de protection d'un consommateur dans lequel un montage ( 1 ) comprend, pour la détermination d'une surcharge imminente du consommateur ( 2 ), une première voie de courant, qui comprend deux lignes ( 101, 102 ), et un dispositif de contrôle,
**caractérisé en ce que**
le dispositif de contrôle comprend une première unité de mesure de la température, une unité ( 4 ) d'exploitation et un premier élément ( 10 ) de mesure, qui ménage une liaison conductrice de l'électricité entre les deux lignes ( 101, 102 ) de la première voie de courant, la première unité de mesure de la température étant séparée galvaniquement du premier élément ( 10 ) de mesure et comprenant une première et une deuxième sondes ( 11, 12 ) de température, la première et la deuxième sondes ( 11, 12 ) détectant en même temps respectivement une température du premier élément ( 10 ) de mesure et l'unité ( 4 ) d'exploitation déterminant une surcharge imminente du consommateur ( 2 ) à l'aide des températures détectées de la première unité de mesure de la température.

13. Procédé suivant la revendication 12, dans lequel l'unité ( 4 ) d'exploitation détermine, à l'aide des températures détectées en même temps de la première unité de mesure de la température, un échauffement provoqué par le courant, du premier élément ( 10 ) de mesure.

## FIG 1

## FIG 2

FIG 3